# EUROPEAN PATENT APPLICATION

(11) **EP 2 072 639 A1**
(43) Date of publication of application: **24.06.2009**
(21) Application number: 08171570.8
(22) Date of filing: 12.12.2008
(51) Int. Cl.: C23F 1/28, C23F 1/44, H01L 21/3213, H01L 23/495, H05K 3/06, H05K 3/38, C25D 5/40, C25F 3/06

(54) **Method for adhesion promotion between the nickel and nickel alloy layer and another metal or a dielectric, such as in the manufacture of lead frames for semiconductor devices**

(30) Priority: 12.12.2007 US 7393 P
(71) Applicant: Rohm and Haas Electronic Materials LLC, Marlborough, MA 01752 (US)
(72) Inventor: Egli, Andre, 6260 Reiden (CH); Wan, Leo, Hong Kong (CN); Wong, Ted, Hong Kong (CN)
(74) Representative: Kent, Venetia Katherine

(57) **Abstract**

Methods for etching nickel and nickel alloy layers are disclosed. The etching compositions include inorganic acids and heterocyclic nitrogen compounds. Additionally, the etching methods may include anodic etching of the nickel or nickel alloy layer. The methods may be used in semiconductor packaging manufacture.

## Description

The present invention is directed to adhesion promotion of molds to nickel plated lead frames of semiconductor integrated circuit (IC) devices. More specifically, the present invention is directed to adhesion promotion of molds to nickel plated lead frames of semiconductor integrated devices to enhance adhesion between the molds and the nickel plated lead frames.

Lead frames are usually manufactured in long strips of many individual units. The long strips may be wide enough to accommodate from one to five lead frames. A lead frame may be equipped with carrier rails and guide holes to position the lead frames during manufacture. The lead frames may be comprised of a plurality of leads having lead ends and lead fingers, tie bars and die pad. The die pad is centrally located on the lead frame and provides the area on which a semiconductor chip may be mounted. When a strip is more than one lead frame wide, the strip is referred to as a matrix.

Most IC devices are assembled around a lead frame. Conventional lead frame plating processes, produce lead frames with clean, non-reactive finishes of silver, palladium, nickel or copper. The die pad of such a lead frame is downset during packaging and a chip, such as a silicon wafer or semiconductor chip is affixed to the die pad. Connection areas on the chip, e.g., bond pads, are connected to the lead frame's lead fingers by wire bonds. Excess lead frame material, such as the carrier rails, may then be trimmed away and the die pad, chip, leads and associated connections are encapsulated in a plastic mold compound.

A source of failure in semiconductor IC packages is the delamination of the plastic mold compound from the lead frame. This may result from various causes including improper curing of the plastic mold compound and "popcorn failure". Popcorn failure may occur when liquids, such as water, are trapped beneath the encapsulation during packaging of the semiconductor devices or when liquids seep or vapors condense under the plastic mold. Moreover, plastic mold compounds are naturally capable of absorbing liquids from their environment until saturation occurs. Such liquids may be vaporized, e.g., steam, may cause pressure to build up beneath the encapsulation. This pressure build up may cause a catastrophic mold failure.

Encapsulation failure may also result from thermal mismatch between dissimilar device materials, such as between the chip and the die pad, at solder reflow temperatures, e.g., temperatures in the range of 215° to 240° C. Such mismatches may be aggravated by pressure created by the heating of liquids absorbed by the plastic mold compound. The combined effect of these stresses degrades adhesion, leads to delamination, especially between the underside of the die pad and the plastic mold compound, and may cause encapsulation cracking or failure.

Efforts to resolve these problems have involved choosing and developing plastic mold compounds that improve adhesion between the die pad and the plastic mold compound. Encapsulations that are lower stress, stronger, absorb less moisture, and poses better adhesion capabilities have been proposed. Nevertheless, these have not eliminated the problems. Further, because specialized encapsulations are generally more expensive, their use tends to increase the costs of manufacturing.

U.S. 5,459,103 discloses a method of forming a lead frame with strengthened encapsulation adhesion. The method involves plating the lead frame with a copper strike and selectively exposing the copper strike to an oxidizing agent to form a layer of cupric oxide. Such lead frames are fitted with chips and then encapsulated in a plastic mold compound. Although there are methods of strengthening encapsulation adhesion with copper lead frames, there is still a need for improving adhesion of nickel or nickel alloy to mold compounds and to reduce the moisture sensitivity level to prevent the "popcorn" effect.

In one aspect a method includes providing a composition including one or more inorganic acids and one or more heterocyclic nitrogen compounds; and applying the composition to a nickel or nickel alloy layer to etch the layer.

In another aspect a method includes providing a composition including one or more inorganic acids and one or more heterocyclic nitrogen compounds; applying the composition to a nickel or nickel alloy layer; and applying anodic current to the nickel or nickel alloy layer to etch the nickel or nickel alloy layer.

In a further aspect a method includes applying a composition including one or more inorganic acids and one or more heterocyclic nitrogen compounds, the heterocyclic nitrogen compounds are chosen from thiazoles and mercaptans; and applying the composition to a nickel or nickel alloy to etch the nickel or nickel alloy.

In an additional aspect a method includes providing a composition including one or more inorganic acids and one or more heterocyclic nitrogen compounds, the heterocyclic nitrogen compounds are chosen from thiazoles and mercaptans; applying the composition to a nickel or nickel alloy; and applying anodic current to the nickel or nickel alloy to etch the nickel or nickel alloy.

The etching methods roughen the nickel and nickel alloy layers such that they become textured with asperites. The texturing enables the nickel and nickel alloy to form a bond with another material, such as another metal, which may be deposited on the textured nickel or nickel alloy layer, or with a dielectric material, such as an organic polymer material. Accordingly, the etching methods may be used to etch nickel and nickel alloy layers in the manufacture of various types of articles including components for electronic devices, such as lead frames for semiconductor packaging.

Semiconductor packaging is manufactured with the goal to ensure that the packaging is able to withstand extremes of temperature and humidity and numerous cycles between high and low temperatures. The dielectric that is used to encapsulate the semiconductor has a thermal-expansion coefficient that is different from the thermal-expansion coefficient of the semiconductor chip, leadframe and die-attach material. As a result, as the packaging cycles between high and low temperatures, stresses are created at the interface between the metal and the dielectric. Over time this may lead to fractured wire bonds. Moreover, the stress at the metal-dielectric interfaces can allow moisture to enter the package. This moisture may corrode the metal components of the package and semiconductor chip. If the package is subjected to freezing temperatures, the moisture may expand and cause separation between the dielectric molding compound and the metal. Conversely, if the package is exposed to high temperatures, the moisture may turn to steam and cause separation or in extreme cases, cause the package to experience a "popcorn" effect. The nickel and nickel alloy etching methods provide adhesion with a dielectric material to prevent or reduce the effects of the stresses at the interface between the nickel or nickel alloy and the dielectric material.

As used throughout the specification, the following abbreviations have the following meaning, unless the context clearly indicates otherwise: °C = degrees Centigrade; g = grams; L = liter; mL = milliliter; mm = millimeter; A = amperes; dm = decimeter; µm =micron = micrometer and ppm = parts per million; terms "electroplating", "plating" and "depositing" are used interchangeably throughout the specification; terms the terms "film" and "layer" are used interchangeably throughout the specification. All numerical ranges are inclusive and combinable in any order, except where it is logical that such numerical ranges are construed to add up to 100%.

The etching compositions include one or more inorganic acids. Such acids include, but are not limited to, sulfuric acid, hydrochloric acid, nitric acid and hydrofluoric acid. Typically the inorganic acids are used in amounts of 50 g/L to 500 g/L, or such as from 75 g/l to 250 g/L.

The one or more inorganic acids are mixed with one or more heterocyclic nitrogen compounds. The heterocyclic nitrogen compounds include, but are not limited to, thiazoles and mercaptans. Such heterocyclic nitrogen compounds are included in the etch compositions in amounts of 0.05 g/L to 20 g/L or such as from 0.1 g/L to 15 g/L.

Mercaptans include, but are not limited to, mercaptotriazoles and mercaptotetrazoles. Such mercaptans may be prepared from the literature or may be obtained commercially.

Mercaptotriazoles have the following general formula: 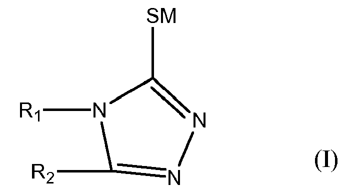 wherein M is hydrogen, NH₄, sodium or potassium and R₁ and R₂ are independently (C₁ to C₁₈)alkyl, substituted or unsubstituted or (C₆ to C₁₀)aryl, substituted or unsubstituted. Substituent groups include, but are not limited to, alkoxy, phenoxy, halogen, nitro, amino, sulfo, sulfamyl, substituted sulfamyl, sulfonylphenyl, sulfonyl-alkyl, fluorosulfonyl, sulfonamidophenyl, sulfonamido-alkyl, carboxy, carboxylate, ureido, carbamyl, carbamyl-phenyl, carbamylalkyl, carbonylalkyl and carbonylphenyl. Such mercaptotriazoles include, but are not limited to, 5-ethyl-3-mercapto-4-phenyl-1,2,4-triazole, 3-mercapto-5-pentyl-4-phenyl-1,2,4-triazole, 4,5-diphenyl-3-mercapto-1,2,4-triazole, 3-mercapto-4-phenyl-5-undecyl-1,2,4-triazole, 4,5-diethyl-3-mercapto-1,2,4-triazole, 4-ethyl-3-mercapto-5-pentyl-1,2,4-triazole, 4-ethyl-3-mercapto-5-phenyl-1,2,4-triazole, 5-p-aminophenyl-4-ethyl-3-mercapto-1,2,4-triazole, 5-p-acetoamidephenyl-4-ethyl-3-mercapto-1,2,4-triazole, 5-p-capronamidephenyl-4-ethyhl-3-mercapto-1,2,4-triazole and 4-ethyl-5-p-lauroamidephenyl-3-mercapto-1,2,4-triazole.

Mercaptotetrazoles have the following general formula: 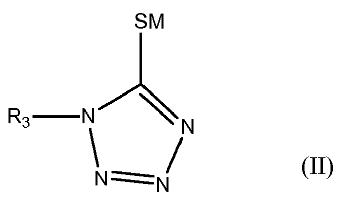 where M is hydrogen, NH₄, sodium or potassium and R₃ is (C₁ to C₂₀)alky, substituted or unsubstituted, or (C₆ to C₁₀)aryl, substituted or unsubstituted. Substituents include, but are not limited to, alkoxy, phenoxy, halogen, nitro, amino, substituted amino, sulfo, sulfamyl, substituted sulfamyl, sulfonylphenyl, sulfonyl-alkyl, fluorosulfonyl, sulfoamidophenyl, sulfonamide-alkyl, carboxy, carboxylate, ureido carbamyl, carbamyl-phenyl, carbamylalkyl, carbonylalkyl and carbonylphenyl. Such mercaptotetrazoles include, but are not limited to, 1-(2-dimethylaminoethyl)-5-mercapto-1,2,3,4-tetrazole, 1-(2-diethylaminoethyl)-5-mercapto-1,2,3,4-tetrazole, 1-(3-methoxyphenyl)-5-mercaptotetrazole, 1-(3-ureidophenyl)-5-mercaptotetrazole, 1-((3-N-carboxymethyl)-ureidophenyl)-5-mercaptotetrazole, 1-((3-N-ethyl oxalamido)phenyl)-5-mercaptotetrazole, 1-(4-acetamidophenyl)-5-mercapto-tetrazole and 1-(4-carboxyphenyl)-5-mercaptotetrazole.

Thiazoles have the following formula: 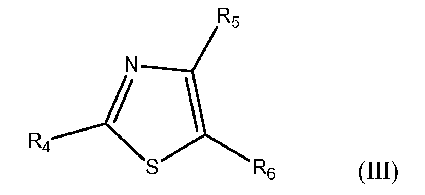 wherein R₄, R₅ and R₆ are the same or different and are hydrogen, (C₁ to C₂₀)alkyl, substituted or unsubstituted, phenyl, substituted or unsubstituted, halogen, amino, alkylamino, dialkylamino, hydroxy, alkoxy, carboxy, carboxyalkyl, alkoxycarbonyl, aminocarbonyl, R₇-CONH- wherein R₇ is hydrogen, (C₁ to C₂₀)alkyl, substituted or unsubstituted, phenyl, substituted or unsubstituted and wherein R₄, R₅ and R₆ can be part of a homo or heterocyclic ring condensed to the thiazole ring. Substituent groups include, but are not limited to, alkoxy, phenoxy, halogen, nitro, amino, substituted amino, sulfo, sulfamyl, substituted sulfamyl, sulfonylphenyl, sulfonyl-alkyl, fluorosulfonyl, sulfoamidophenyl, sulfonamide-alkyl, carboxy, carboxylate, ureido carbamyl, carbamyl-phenyl, carbamylalkyl, carbonylalkyl and carbonylphenyl. Such thiazoles include, but are not limited to, aminothiazoles, substituted and unsubstituted.

Typically, the mercaptotetrazoles are used in the etch compositions. More typically the mercaptotetrazoles where R₃ includes an amino substituent, substituted or unsubstituted, are included in the etch compositions.

The nickel or nickel alloy containing article may be immersed in the etch composition or the composition may be sprayed on the nickel or nickel alloy layer. Typically, the nickel or nickel alloy layer is treated with the etch composition for at least 1 second or such as from 3 seconds to 20 seconds or such as from 5 to 10 seconds to texture the nickel or nickel alloy layer. The asperites formed on the nickel or nickel alloy layer by the etching method promotes adhesion between the textured nickel or nickel alloy layer and another metal or dielectric material deposited on the textured nickel or nickel alloy layer.

Etching is done at temperatures of from 18° C to 40° C. Typically the etching is done at temperatures of 20° C to 30° C.

Optionally, anodic etching may be done in combination with the etching composition. When anodic etching is done, the article containing the nickel or nickel alloy layer is immersed in the etch composition. The inorganic acids of the etch composition act as conducting agents to provide a complete electrical circuit. Also immersed in the etch composition is an auxiliary or counter electrode, such as a platinum/titanium or stainless steel electrode. A reference electrode, such as a dynamic hydrogen electrode, also is immersed in the etch composition. The article with the nickel or nickel alloy layer, the auxiliary electrode and the reference electrode are all independently connected to a voltage supply, for example, a potentiostat by insulated conductors or wires. The potentiostat is used to apply an anodic voltage to the nickel or nickel alloy layer and a cathodic voltage to the auxiliary electrode. Etching time is the same as described above when the nickel or nickel alloy layer is etched only with the etch composition.

Anodic etching is done at cathode current densities of 0.01 A/dm² to 30 A/dm² or such as from 1 A/dm² to 25 A/dm². Typically anodic etching is done at cathode current densities of 10 A/dm² to 20 A/dm².

The methods of etching nickel and nickel alloys may be used to texture a nickel or nickel alloy layer to promote adhesion between the nickel and nickel alloy layer and another metal or a dielectric in any industry where such adhesion promotion is desired, such as in the manufacture of lead frames for semiconductor devices. The methods enhance adhesion between the nickel or nickel alloy and prevent or reduce stresses created at the interfaces between the nickel or nickel alloy and the other metal layer or the dielectric. The reduction in stress at the interfaces prevents or reduces moisture which enters the semiconductor package, thus preventing separation of the components at their interfaces and preventing the "popcorn" effect.

In the process of manufacturing a lead frame, the lead frame is first cleaned. This may be accomplished by using electrolytic cleaners, alkaline cleaners or ultrasonic cleaners or a combination of these. If the lead frame is stamped, oil may be deposited on the lead frame by the stamp apparatus. If the lead frame is etched, excess photoresist may remain on the lead frame after etching. Such oil or excess photoresist is removed during cleaning.

Electrolytic cleaning may be accomplished in at least two ways. First, lead frames may be drawn through a fluid bath in which they are exposed to positive and negative electrodes submersed in the bath. Dirt and manufacturing residue, such as oil and photoresist, which may be clinging to the lead frame, transfer to the negative electrode. Alternatively, a plurality of negative electrodes may be submersed in the bath and a positive charge may be applied to the lead frame. Again, dirt and residue clinging to the lead frame transfer to the negative electrodes. The bath may include alkaline cleaners, i.e., and aqueous solution of a compound having a pH greater than 7 for cleaning metals, such as Peptizoid^{™} 143SP/UDYPREP. After cleaning, the surface of the lead frame is chemically activated to ensure more complete and rapid plating. This may be accomplished by exposing the lead frame in an acid bath.

After the lead frame has been acitivated a nickel or nickel alloy layer is deposited on the lead frame. Conventional electrochemical or electroless nickel or nickel alloy plating baths may be used to deposit a layer of nickel or nickel alloy. Nickel alloys include, but are not limited to nickel/gold, nickel/palladium and nickel/palladium/gold. Typically, lead frames are made from metals such as copper, nickel, nickel alloys, silver, gold, palladium and aluminum. If the lead frame is composed of nickel or nickel alloy, the activation step is not necessary since no nickel or nickel alloy coat is needed, and the etching step is done without activation. However, cleaning is typically done before etching. If the lead frame is made of a metal other than nickel or nickel alloy, the lead frame is plated with nickel or nickel alloy using conventional plating methods. Etching with the etching composition is then done. Alternatively, etching may be done simultaneously with the etching composition and anodic etching.

After the nickel or nickel alloy layer is etched, the semiconductor die is attached to the die-attach pad, wire bonds are completed, and the assembly is encapsulated in a dielectric capsule. Encapsulation is accomplished by positioning the lead frames in a mold cavity and injecting a heated molten dielectric or molding compound into the mold cavity under pressure. The molding compound is then allowed to cure and the mold is removed, leaving the cured molding compound at least partially surrounding the lead frame and die. Separation may occur at any location where the molding compound is in contact with the lead frame. The molding compound may be a polymer or other epoxy material, such as Ortho Cresol Novolac Epoxy^{™} (OCN), biphenyl epoxy and dicyclopentadiene epoxy (DCPD).

Alternatively, one or more additional metal layers may be selectively deposited on the nickel or nickel alloy layer prior to encapsulation. In the packaging of semiconductor IC devices, lead ends and lead fingers of the lead frame may be spot-plated or strike-plated with precious metals, such as silver, palladium or gold. Thus, a precious metal strike may be selectively plated on the nickel or nickel alloy layer of the lead frame. The strike may be selectively plated by means of (1) mechanical masking of the lead frame, (2) photoresist-type masking, or (3) ring plating. Such selective plating methods are well known in the art.

A precious metal such as palladium or silver may be plated to a nickel or nickel alloy lead frame by at least two methods. First, the precious metal may be selectively plated to the nickel or nickel alloy lead ends of lead fingers before the lead frame is etched. Second, a photoresist may be applied to the lead frame. The photoresist is applied to the lead frame according to a pattern defining areas that are subsequently to be plated wit palladium or silver. The photoresist is then exposed to actinic radiation and developed. After the photoresist has been developed, the unexposed photoresist is washed away and the lead frame may then be etched. The exposed photoresist is then dissolved leaving a lead frame which is selectively etched and plated with palladium or silver. The lead frame may then be encapsulated with a molding compound. Alternatively, another metal layer may be deposited on the palladium or silver, such as gold. Gold may be deposited on the palladium or silver using conventional electrochemical of electroless processes. The lead frame is then encapsulated with a molding compound.

The etching methods provide a textured nickel or nickel alloy layer which enhances adhesion between the nickel and nickel alloy layer and molding compounds during encapsulation. Accordingly, the separation that occurs due to thermal expansion and moisture ingress into a semiconductor package is reduced.

While the methods are described with respect to the manufacture of a lead frame in semiconductor packaging, the methods for etching nickel and nickel alloys may be used in the manufacture of other articles where nickel and nickel alloy etching is desirable. Other articles include, but are not limited to, connectors, optoelectronic components and printed circuit boards.

The following examples are intended to further illustrate embodiments of the invention but are not intended to limit the scope of the invention.

### Example 1

Five brass lead frames are electrolytically cleaned in an aqueous solution of Peptizoid^{™} 143P/UDYREP. The lead frames are drawn through the fluid bath where the lead frames are exposed to platinum/titanium positive and negative electrodes submersed in the aqueous solution. The pH of the aqueous solution is 7.

After the lead frames are cleaned, they are rinsed with deionized water and activated with a solution of dilute sulfuric acid. The lead frames are again rinsed with deionized water and then plated with a 5µm layer of nickel metal using the nickel electroplating formulation disclosed in the table below.

**Table 1**

| **COMPONENT** | **AMOUNT** |
|---|---|
| Nickel sulfate hexahydrate | 100 g/l |
| Sodium salt of ethylenediamine tetraacetic acid | 40 g/L |
| Sodium citrate | 60 g/L |
| Ammonium chloride | 35 g/L |
| Triethanolamine | 35 g/L |
| pH | 8 |

Electrochemical plating is done at 60° C at a current density of 2 A/dm². The nickel coated lead frames are then rinsed with deionized water and each lead frame is immersed in an etching composition which includes which includes 10w% sulfuric acid, 10wt% hydrochloric acid and 5 g/l of 1-(2-dimethylaminoethyl)-5-mercapto-1,2,3,4-tetrazole.

A counter electrode of platinum/titanium and a hydrogen reference electrode is immersed in each etching composition containing a nickel coated lead frame. The lead frames, counter electrode and reference electrode are connected to a potentiostat. The potentiostat applies anodic voltage to the lead frames and a cathodic voltage to the platinum/titanium auxiliary electrode. Etching is done at 30° C for 5 seconds. The current density is at 10 A/dm².

After the lead frames are etched they are removed from the etching composition and rinsed with deionized water. The nickel plated lead frames are then activated with a dilute solution of sulfuric acid. A patterned mask is applied to the etched nickel layers for selective plating of a palladium layer. The electrochemical palladium composition is disclosed in Table 2 below.

**Table 2**

| **COMPONENT** | **AMOUNT** |
|---|---|
| Palladium ammonium sulfate | 15 g/L |
| Boric acid | 26 g/L |
| Ammonium sulfate | 35 g/L |
| pH | 7 |

Electroplating is done at a current density of 10 A/dm² at 50° C until a palladium layer of 2µm is selectively deposited on the etched nickel layer. The lead frames are then rinsed with deionized water.

A patterned mask is applied to the lead frames and the lead frames are sprayed with an autocatalytic electroless gold bath to deposit a 1µm layer of gold on the palladium layer. The autocatalytic electroless gold bath is disclosed in the table below.

**Table 3**

| **COMPONENT** | **AMOUNT** |
|---|---|
| Potassium gold cyanide | 1 g/L |
| Potassium cyanide | 0.17 mol/L |
| Disodium ethylenediaminetetraacetic acid | 0.013 mol/L |
| Potassium hydroxide | 0.2 mol/L |
| Ethanolamine | 0.8 mol/L |
| Tetrahydroboric acid | 0.2 mol/L |
| pH | 10 |

The gold plated lead frames are then rinsed with deionized water and air dried. After the lead frames are air dried they are encapsulated with biphenyl epoxy. The lead frames are positioned in a conventional mold cavity and heated biphenyl epoxy is injected into the mold, which is under pressure. The biphenyl epoxy is allowed to cure and the mold is removed leaving the cured biphenyl epoxy surrounding the lead frames. No evidence of separation or cracking of the biphenyl epoxy from the lead frames is expected. Also no "popcorn" effect is expected.

### Example 2

Five brass lead frames are electrolytically cleaned in an aqueous solution of Peptizoid^{™} 143P/UDYREP. The lead frames are drawn through the fluid bath where the lead frames are exposed to platinum/titanium positive and negative electrodes submersed in the aqueous solution. The pH of the aqueous solution is 7.

The lead frames are then rinsed with deionized water and activated with a dilute solution of hydrochloric acid. The lead frames are again rinsed with deionized water and then electroplated with a 5µm layer of nickel using the nickel bath disclosed in Table 1 in Example 1.

Each nickel plated lead frame is then etched for 5 seconds using an etching composition of 10wt% sulfuric acid, 10wt% hydrochloric acid and 10 g/L of 1-(2-diethylaminoethyl)-5-mercapto-1,2,3,4-tetrazole.

The etched lead frames are then are then rinsed with deionized water and air dried. After the lead frames are air dried they are encapsulated with DCPD epoxy. The lead frames are positioned in a conventional mold cavity and heated DCPD epoxy is injected into the mold, which is under pressure. The DCPD epoxy is allowed to cure and the mold is removed leaving the cured epoxy surrounding the lead frames. No evidence of separation or cracking of the epoxy from the lead frames is expected. Also no "popcorn" effect is expected.

### Example 3

Five copper lead frames are electrolytically cleaned in an aqueous solution of Peptizoid^{™} 143P/UDYREP. The lead frames are drawn through the fluid bath where the lead frames are exposed to platinum/titanium positive and negative electrodes submersed in the aqueous solution. The pH of the aqueous solution is 7.

After the lead frames are cleaned, they are rinsed with deionized water and activated with a solution of dilute sulfuric acid. The lead frames are again rinsed with deionized water and then plated with a 5µm layer of nickel/phosphorous alloy metal using the nickel alloy electroplating formulation disclosed in the table below.

**Table 4**

| **COMPONENT** | **AMOUNT** |
|---|---|
| Nickel dichloride hexahydrate | 0.75 moles/L |
| Nickel carbonate | 0.25 moles/L |
| Phosphorous acid | 1.25 moles/L |

Electrochemical plating is done at 50° C at a current density of 10 A/dm². The nickel/phosphorous coated lead frames are then rinsed with deionized water and each lead frame is immersed in an etching composition which includes which includes 10w% sulfuric acid, 10wt% hydrochloric acid and 1 g/l of 3-mercapto-5-methyl-4-phenyl-1,2,4-triazole. Etching is done for 10 seconds.

After the lead frames are etched they are removed from the etching composition and rinsed with deionized water. The nickel/phosphorous plated lead frames are then activated with a dilute solution of sulfuric acid. A patterned mask is applied to the etched nickel layers for selective plating of a palladium layer. The electrochemical palladium composition is disclosed in Table 2 of Example 1.

Electroplating is done at a current density of 10 A/dm² at 50° C until a palladium layer of 2µm is selectively deposited on the etched nickel/phosphorous layer. The lead frames are then rinsed with deionized water.

A patterned mask is applied to the lead frames and the lead frames are sprayed with an autocatalytic electroless gold bath to deposit a 1µm layer of gold on the palladium layer. The autocatalytic electroless gold bath is disclosed in Table 3 in Example 1.

The gold plated lead frames are then rinsed with deionized water and air dried. After the lead frames are air dried they are encapsulated with OCN epoxy. The lead frames are positioned in a conventional mold cavity and heated biphenyl epoxy is injected into the mold, which is under pressure. The OCN epoxy is allowed to cure and the mold is removed leaving the cured epoxy surrounding the lead frames. No evidence of separation or cracking of the OCN epoxy from the lead frames is expected. Also no "popcorn" effect is expected.

### Example 4

The etching, metallization and encapsulation of lead frames as described in Example 1 is repeated except that the lead frames are copper and the etch composition includes 5wt% sulfuric acid, 5wt% hydrochloric acid and 10 g/L of an aminothiazole.

No evidence of separation or cracking of the biphenyl epoxy from the lead frames is expected. Also no "popcorn" effect is expected.

## Claims

1. A method comprising:
a) providing a composition comprising one or more inorganic acids, one or more heterocyclic nitrogen compounds; and
b) applying the composition to a nickel or nickel alloy layer to etch the layer.

2. The method of claim 1, further comprising the step of anodic etching the nickel or nickel alloy.

3. The method of claim 1, wherein the heterocyclic nitrogen compounds are chosen from thiazoles and mercaptans.

4. The method of claim 3, wherein the mercaptans are chosen from mercaptotriazoles and mercaptotetrazoles.

5. The method of claim 1, wherein the mercaptotriazoles have a formula: 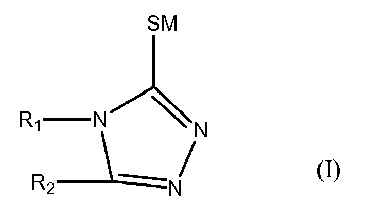 wherein M is hydrogen, NH₄, sodium or potassium and R₁ and R₂ are independently (C₁ to C₁₈)alkyl, substituted or unsubstituted or (C₆ to C₁₀)aryl, substituted or unsubstituted.

6. The method of claim 1, wherein the mercaptotetrazoles have a formula: 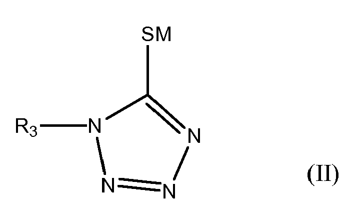 where M is hydrogen, NH₄, sodium or potassium and R₃ is (C₁ to C₂₀)alky, substituted or unsubstituted, or (C₆ to C₁₀)aryl, substituted or unsubstituted.

7. The method of claim 1, wherein the thiazoles have a formula: 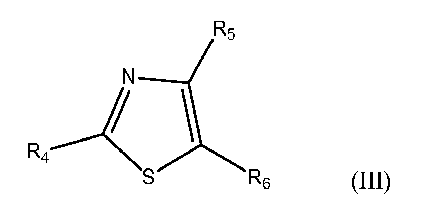 wherein R₄, R₅ and R₆ are the same or different and are hydrogen, (C₁ to C₂₀)alkyl, substituted or unsubstituted, phenyl, substituted or unsubstituted, halogen, amino, alkylamino, dialkylamino, hydroxy, alkoxy, carboxy, carboxyalkyl, alkoxycarbonyl, aminocarbonyl, R₇-CONH- wherein R₇ is hydrogen, (C₁ to C₂₀)alkyl, substituted or unsubstituted, phenyl, substituted or unsubstituted and wherein R₄, R₅ and R₆ can be part of a homo or heterocyclic ring condensed to the thiazole ring.

8. The method of claim 1, further comprising depositing one or more precious metal on the etched nickel or etched nickel alloy layer.

9. The method of claim 8, wherein the one or more precious metal is selectively deposited on the etched nickel or etched nickel alloy layer.

10. The method of claim 1, wherein the etched nickel or etched nickel alloy layer is encapsulated with a dielectric.
